(19) Europäisches Patentamt
European Patent Office
Office européen des brevets

(11) **EP 2 574 941 A2**

(12) **EUROPEAN PATENT APPLICATION**

(43) Date of publication:
**03.04.2013 Bulletin 2013/14**

(51) Int Cl.:
***G01R 31/12*** *(2006.01)*

(21) Application number: **12186651.1**

(22) Date of filing: **28.09.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.09.2011 KR 20110099052**

(71) Applicant: **Hyundai Heavy Industries Co., Ltd. Ulsan 682-792 (KR)**

(72) Inventors:
• **Park, Chang-Sun**
  **Dong-gu**
  **Ulsan (KR)**

• **Park, Jin-Ho**
  **Gyeonggi-do (KR)**
• **Kim, Jung-Han**
  **Gyeonggi-do (KR)**
• **Hong, Cheol-Yong**
  **Ulsan (KR)**

(74) Representative: **Robertson, James Alexander**
**Marks & Clerk LLP**
**90 Long Acre**
**London**
**WC2E 9RA (GB)**

(54) **Method of estimating location of partial discharge using signal attenuation rate in GIS tank**

(57) Provided is a method of estimating a location of partial discharge using a signal attenuation rate in a gas insulated switchgear (GIS) tank. The method includes a process (S 100) of constructing a coordinate system database of each tank of the GIS, a process (S200) of constructing an electromagnetic wave signal attenuation rate database of each structure of a GIS, a process (S300) of performing a location estimating algorithm, and a process (S400) of determining the tank at which the partial discharge occurs based on a result of performing the location estimating algorithm.

FIG. 1

EP 2 574 941 A2

## Description

BACKGROUND OF THE INVENTION

1. Field of the Invention

The present invention relates to an external communication method of an on-line gas insulated switchgear (GIS), and more particularly, to a method of estimating a location of partial discharge using a signal attenuation rate in a GIS tank, capable of measuring an electromagnetic wave signal attenuation rate of each structure constituting a GIS, and estimating the location of partial discharge when the partial discharge occurs in the GIS.

2. Description of the Related Art

A gas insulated switchgear (GIS) is important equipment that controls a high-voltage power system. Defects of GIS serve as one of factors causing serious power-off disturbance. Since this is responsible for an enormous loss to the economy, a system capable of preventing this condition is required.

Such a GIS preventive diagnosis system is a system that measures the leakage of insulating gas or the partial discharge that is an indication of electrical breakdown, thereby informing of a cause of failure in a rapid and accurate way.

Currently, with regard to new GISs having a design voltage of 170 kV or more, an internally mounted partial discharge sensor capable of measuring the partial discharge should be attached when the GIS is delivered. In the case of previously installed GISs, there shows a tendency to attach an internally or externally mounted partial discharge sensor according to a plan of suspension of power supply. In this way, the importance of a GIS preventive diagnosis function is enhanced as time goes on.

Further, as the distribution of the GIS preventive diagnosis system gradually increases, the requests of customers with regard to knowledge of the partial discharge, countermeasures when the partial discharge occurs, etc., are increasing.

The GIS preventive diagnosis system was first developed in 1992 by DMS (Diagnostic Monitoring Systems Ltd.), and has been developed by numerous small-and-medium preventive diagnosis enterprises including Hyundai Heavy Industries, Hyosung Power & Industrial Systems Performance Group, LS Industrial Systems, SIEMENS, ABB, etc. which are domestic and foreign GIS manufacturers.

However, all the GIS preventive diagnosis systems merely analyze and diagnose defect causes with regard to a temporary partial discharge phenomenon, and fail to provide the interpretation of a partial discharge signal depending on a GIS internal structure, location information about a partial discharge source, and so on.

Furthermore, a method of diagnosing the defect causes of the partial discharge has a limitation in that, when the partial discharge occurs, an on-site engineer of the GIS undergoing the partial discharge understands only the partial discharge phenomenon, and does not present a correct countermeasure of how to cope with the partial discharge.

For example, when the partial discharge whose defect cause is diagnosed as a particle occurs, it is impossible to accurately detect in which tank of the GIS the particle is located, and thus to immediately cope with the partial discharge. To check a location at which the partial discharge occurs, an engineer should measure the location using an externally mounted sensor and an oscilloscope with additional time and cost.

For this reason, to estimate the location of the partial discharge, it additionally takes a greater annual cost. Requests to include a function capable of estimating the location of the partial discharge when the partial discharge occurs continue to be made on site when GISs are delivered.

For this reason, it is essential to develop a technique for estimating the location of the partial discharge. Accordingly, the present invention is directed to develop a function capable of measuring an electromagnetic wave signal attenuation rate of each structure constituting the GIS, and estimating the location of the partial discharge when the partial discharge occurs in the GIS on the basis of the measured attenuation rate, and to apply the function to a system.

SUMMARY OF THE INVENTION

The present invention provides a method of estimating a location of partial discharge using a signal attenuation rate in a gas insulated switchgear (GIS) tank, by which a function capable of measuring an electromagnetic wave signal attenuation rate of each structure constituting a GIS and estimating the location of the partial discharge when the partial discharge occurs in the GIS on the basis of the measured attenuation rate can be developed and applied to a system.

According to one aspect of the present invention, a method of estimating a location of partial discharge using a signal attenuation rate in a gas insulated switchgear (GIS) tank includes a process (S100) of constructing a coordinate system database of each tank of the GIS, a process (S200) of constructing an electromagnetic wave signal attenuation rate database of each structure of a GIS, a process (S300) of performing a location estimating algorithm by detecting a partial discharge signal of each structure using two sensors installed on the structure of each tank when the partial discharge occurs in the GIS, selecting the two sensors on the structure in which the partial discharge signal has a strongest intensity, and comparing the electromagnetic wave attenuation rate database of each structure of the GIS and the detected values of the two selected sensors to determine location coordinates of the tank at which the partial discharge occurs, and a process (S400) of comparing the location coordinates of the tank at which the partial discharge occurs through a result of performing the algorithm with the electromagnetic wave attenuation rate database, and determining the tank at which the partial discharge occurs

Here, the process (S100) of constructing the coordinate system database of each tank of the GIS may include a process (S110) of checking a location of each tank using a drawing of the GIS, and a process (S120) of building up relative coordinates of each tank whose location is checked.

Further, the process (S200) of constructing the electromagnetic wave attenuation rate database of each structure of the GIS may include a process (S210) of measuring a partial discharge attenuation rate of each structure of the GIS, and a process (S220) of constructing a partial discharge attenuation rate database of each structure of the GIS using the measured attenuation rate.

Also, the process (S210) of measuring the partial discharge attenuation rate of each structure of the GIS may include mounting two externally mounted ultra high frequency (UHF) sensors (A and B) on the GIS, and inputting a UHF signal from a partial discharge generator into the GIS via an internally mounted sensor, and measuring a UHF signal attenuation rate at which, while the input signal is passing through a section (M) between the sensors (A and B), an intensity of the input signal is attenuated from $Q_A$ (an intensity of the UHF signal measured just before the GIS section (M) for measuring the attenuation rate) to $Q_B$ (an intensity of the UHF signal passing through the GIS section (M) for measuring the attenuation rate).

In the process (S300) of performing the location estimating algorithm, when the intensity of the signal measured by the sensor (A) is set to $Q_A$, when the intensity of the signal measured by the sensor (B) is set to $Q_B$, when a function in which the intensity of the signal that is gradually increased at the sensor (A) depending on a distance in a direction of the sensor (B) is expressed by $Q_A(x)$, and when a function in which the intensity of the signal that is gradually increased at the sensor (B) depending on a distance in a direction of the sensor (A) is expressed by $Q_B(x)$, a location of a partial discharge source may be estimated to be a point at which $Q_A(x)$ and $Q_B(x)$ join each other.

In the process (S400) of comparing the location coordinates of the tank at which the partial discharge occurs through the result of performing the algorithm with the coordinate system database of each tank of the GIS and determining the tank at which the partial discharge occurs, when n tanks are installed between the sensors (A and B), when length of the tanks are set to $l_1, l_2, ...$ , $l_n$, and when the attenuation rates previously measured and constructed into the database are set to $\alpha_1, \alpha_2, ...$ , $\alpha_n$, an attenuation phenomenon of each distance may be represented in a linear form.

As described above, the present invention has an advantage that it is capable of measuring the electromagnetic wave signal attenuation rate of each structure constituting the GIS and easily estimating the location of the partial discharge when the partial discharge occurs in the GIS on the basis of the result of the measurement.

## BRIEF DESCRIPTION OF THE DRAWINGS

The above and other features of the present invention will be described in reference to specific exemplary embodiments thereof with reference to the attached drawings in which:

FIG. 1 shows a flow of processing a method of estimating a location of partial discharge using a signal attenuation rate in a GIS tank in accordance with the present invention;

FIG. 2 shows a state in which two externally mounted UHF sensors A and B are mounted on a GIS in the method of estimating a location of partial discharge using a signal attenuation rate in a GIS tank in accordance with the present invention;

FIG. 3 schematically shows a partial discharge location estimating algorithm in the method of estimating a location of partial discharge using a signal attenuation rate in a GIS tank in accordance with the present invention;

FIG. 4 shows a GIS model that is expressed by simplification as a set of structures having an attenuation rate and a distance in the method of estimating a location of partial discharge using a signal attenuation rate in a GIS tank in accordance with the present invention;

FIG. 5 shows a typical GIS attenuation model between two sensors in the method of estimating a location of partial discharge using a signal attenuation rate in a GIS tank in accordance with the present invention; and

FIG. 6 is a graph showing an attenuation signal according to each GIS distance between two sensors in the method of estimating a location of partial discharge using a signal attenuation rate in a GIS tank in accordance with the present invention.

## DETAILED DESCRIPTION OF THE INVENTION

Hereinafter, exemplary embodiments of the present invention will be described in detail with reference to accompanying drawings.

In the description of the present invention, technical terms are terms defined in consideration of their functions in the present invention, and should not be construed as limited to technical components of the present invention.

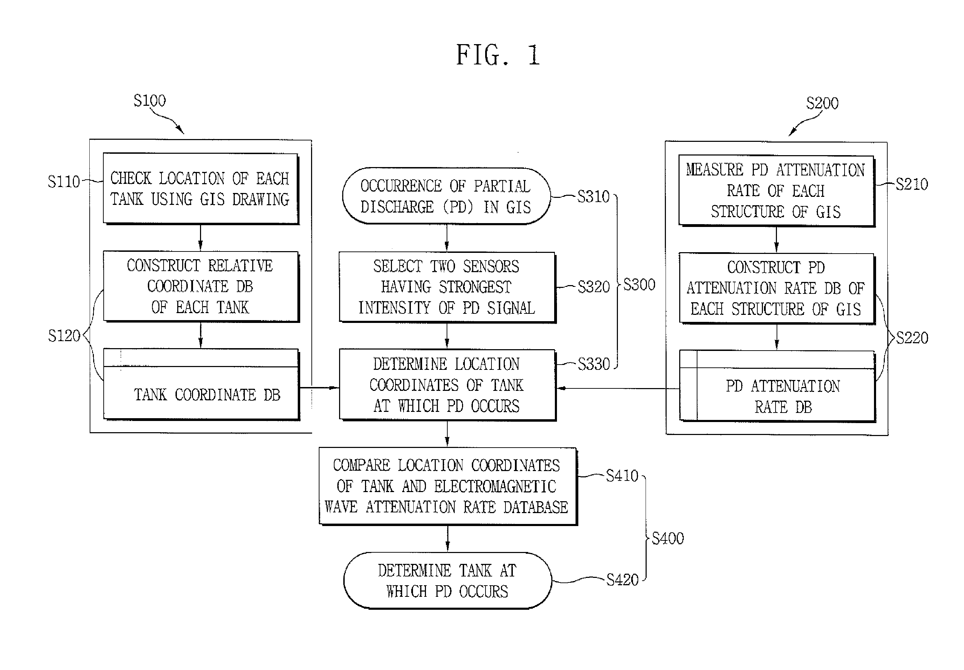

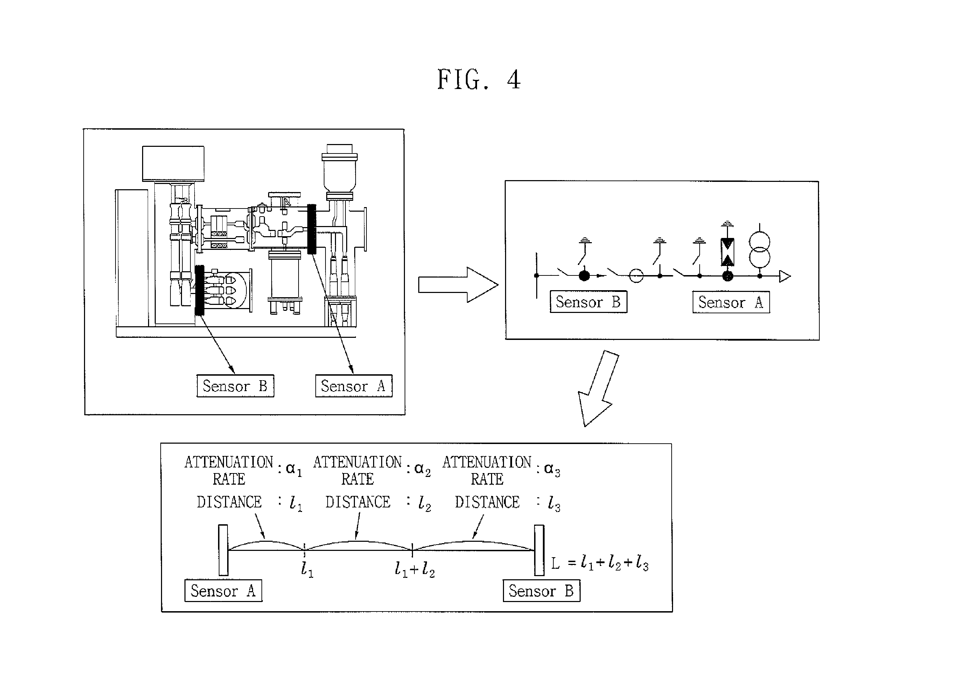

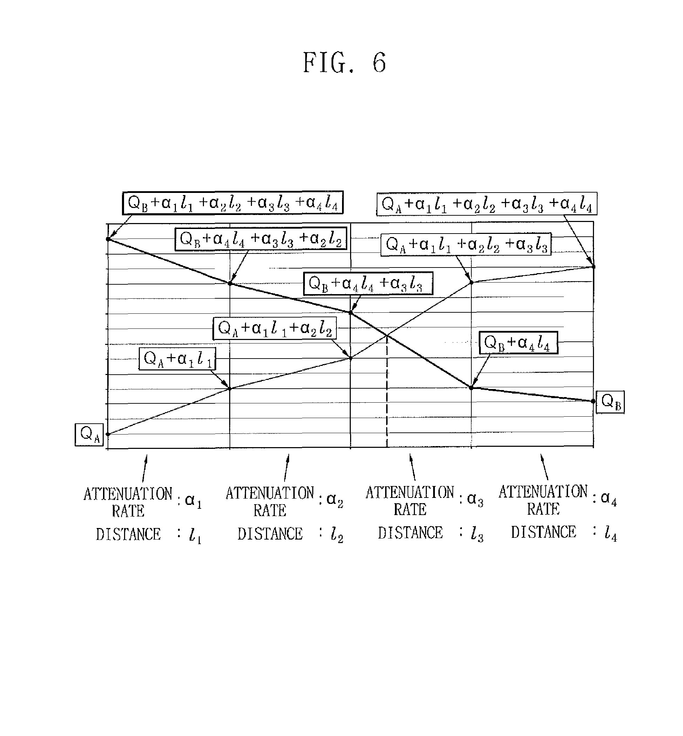

As shown in FIGS. 1 to 6, a method of estimating a location of partial discharge using a signal attenuation rate in a gas insulated switchgear (GIS) tank in accordance with the present invention is configured to measure a signal attenuation rate of each structure of a GIS to generate a database, to develop an algorithm for estimating the location of partial discharge when the partial discharge occurs in the GIS using the generated attenuation rate database, and to estimate the location.

In the present invention, an ultra high frequency (UHF) sensor is attached to an interior or an exterior of the GIS tank, and a partial discharge signal is acquired. Thereby, it is checked whether or not the partial discharge occurs in the GIS.

In the present invention, a difference in intensity of the partial discharge signal reaching two sensors is used. The intensity of the partial discharge signal is attenuated in the process of passing through each structure of the GIS. Thus, a method of previously analyzing an attenuation rate pattern of each structure of the GIS, making the analyzed attenuation rate pattern into a database, and applying this database is employed.

To this end, the method of estimating a location of partial discharge using a signal attenuation rate in a GIS tank in accordance with the present invention includes a process S100 of constructing a coordinate system database of each tank of the GIS, as shown in FIG 1. Here, the process S100 of constructing a coordinate system database of each tank of the GIS may include a process S110 of checking a location of each tank using a drawing of the GIS, and a process S120 of building up relative coordinates of each tank whose location is checked.

Next, a process S200 of constructing an electromagnetic wave attenuation rate database of each structure of the GIS is advanced. The process S200 of constructing an electromagnetic wave attenuation rate database of each structure of the GIS may include a process S210 of measuring a partial discharge attenuation rate of each structure of the GIS, and a process S220 of constructing a partial discharge attenuation rate database of each structure of the GIS using the measured attenuation rate.

Here, the process S210 of measuring the partial discharge attenuation rate of each structure of the GIS is configured to mount two externally mounted UHF sensors A and B on the structure of each tank of the GIS, and to input a UHF signal from a partial discharge generator into the GIS via an internally mounted sensor.

While the input signal is passing through a section M between the sensors A and B, an intensity of the input signal is attenuated from $Q_A$ (an intensity of the UHF signal measured just before the GIS section M for measuring the attenuation rate) to $Q_B$ (an intensity of the UHF signal passing through the GIS section M for measuring the attenuation rate). Thus, a UHF signal attenuation rate can be measured.

Here, the UHF signal attenuation rate is measured based on the following equation:

$$\alpha(dB/m) = \frac{10 \log_{10}(\frac{Q_A}{Q_B})}{L}$$

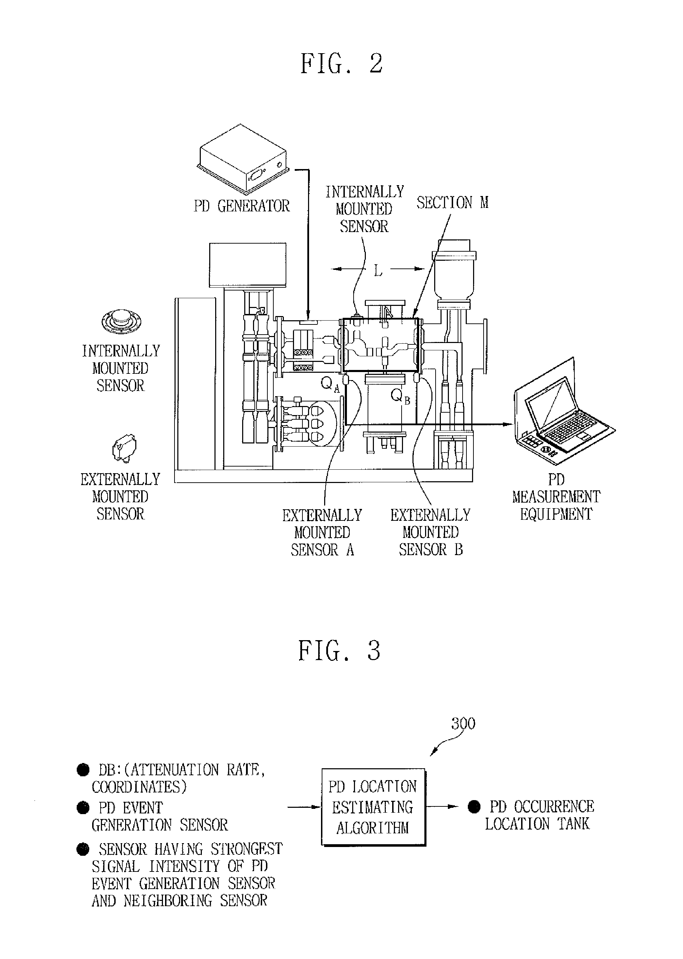

where $Q_A$ is the intensity of the UHF signal measured just before the GIS section (section M of FIG. 2) for measuring the attenuation rate,

$Q_B$ is the intensity of the UHF signal passing through the GIS section (section M of FIG. 2) for measuring the attenuation rate,

L is the length of the GIS section (section M of FIG. 2) for measuring the attenuation rate, and

$\alpha$ is the UHF signal attenuation rate.

Next, a process S300 of performing a location estimating algorithm is advanced.

In detail, when the partial discharge occurs in the GIS (S310), a partial discharge signal of each structure is detected by two sensors installed on the structure of each tank, and the two sensors on the structure in which the partial discharge signal has a strongest intensity are selected (S320). Then, the electromagnetic wave attenuation rate database of each structure of the GIS and the detected values of the two selected sensors are compared to determine location coordinates of the tank at which the partial discharge occurs (S330). In this way, the process S300 of performing the location estimating algorithm is advanced.

Here, in the process S300 of performing the location estimating algorithm using the two sensors, when the intensity of the signal measured by the sensor A is set to $Q_A$, when the intensity of the signal measured by the sensor B is set to $Q_B$, when a function in which the intensity of the signal that is gradually increased at the sensor A depending on a distance in a direction of the sensor B is expressed by $Q_A(x)$, and when a function in which the intensity of the signal that is gradually increased at the sensor B depending on a distance in a direction of the sensor A is expressed by $Q_B(x)$, a location of a partial discharge source can be estimated to be a point at which the two functions $Q_A(x)$ and $Q_B(x)$ intersect each other.

Finally, a process S400 of comparing the location coordinates of the tank at which the partial discharge occurs through a result of performing the algorithm with the electromagnetic wave attenuation rate database of each structure of the GIS, and determining the tank at which the partial discharge occurs is advanced.

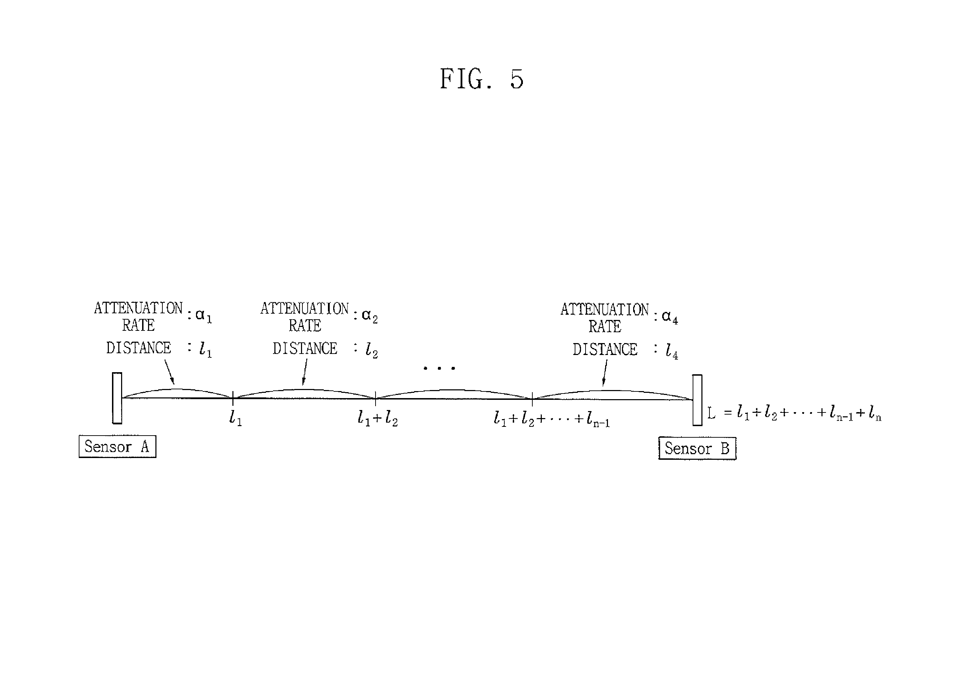

That is, as shown in FIG. 5, in the process S400 of comparing the location coordinates of the tank at which the partial discharge occurs through the result of performing the algorithm with the coordinate system database of each tank of the GIS and determining the tank at which the partial discharge occurs, when n tanks are installed between the sensors A and B, when length of the tanks are set to $l_1, l_2, ... , l_n$, and when the attenuation rates previously measured and constructed into the database are set to $\alpha_1, \alpha_2, \ldots, \alpha_n$, an attenuation phenomenon of each distance can be represented in a linear form.

Consequently, the present invention has an advantage that it is capable of measuring the electromagnetic wave signal attenuation rate of each structure constituting the GIS and easily estimating the location of the partial discharge when the partial discharge occurs in the GIS on the basis of the result of the measurement.

As described above, although the technical principle of the method of estimating a location of partial discharge using a signal attenuation rate in a GIS tank in accordance with the present invention has been described along with the accompanying drawings, it is merely provided for illustration of the most exemplary embodiment of the present invention, but not meant to limit the present invention.

Thus, it will be understood by those skilled in the art that a variety of modifications and variations may be made to the present invention without departing from the spirit or scope of the present invention defined in the appended claims, and their equivalents.

**Claims**

1. A method of estimating a location of partial discharge using a signal attenuation rate in a gas insulated switchgear (GIS) tank, the method comprising:

   a process (S 100) of constructing a coordinate system database of each tank of the GIS;
   a process (S200) of constructing an electromagnetic wave signal attenuation rate database of each structure of a GIS;
   a process (S300) of performing a location estimating algorithm by detecting a partial discharge signal of each structure using two sensors installed on the structure of each tank when the partial discharge occurs in the GIS, selecting the two sensors on the structure in which the partial discharge signal has a strongest intensity, and comparing the electromagnetic wave attenuation rate database of each structure of the GIS and the detected values of the two selected sensors to determine location coordinates of the tank at which the partial discharge occurs; and
   a process (S400) of comparing the location coordinates of the tank at which the partial discharge occurs through a result of performing the algorithm with the electromagnetic wave attenuation rate database, and determining the tank at which the partial discharge occurs.

2. The method according to claim 1, wherein the process (S100) of constructing the coordinate system database of each tank of the GIS includes a process (S110) of checking a location of each tank using a drawing of the GIS, and a process (S120) of building up relative coordinates of each tank whose location is checked.

3. The method according to claims 1 or 2, wherein the process (S200) of constructing the electromagnetic wave attenuation rate database of each structure of the GIS includes a process (S210) of measuring a partial discharge attenuation rate of each structure of the GIS, and a process (S220) of constructing a partial discharge attenuation rate database of each structure of the GIS using the measured attenuation rate.

4. The method according to claim 3, wherein the process (S210) of measuring the partial discharge attenuation rate of each structure of the GIS includes:

   mounting two externally mounted ultra high frequency (UHF) sensors (A and B) on the GIS, and inputting a UHF signal from a partial discharge generator into the GIS via an internally mounted sensor; and
   measuring a UHF signal attenuation rate at which, while the input signal is passing through a section (M) between the sensors (A and B), an intensity of the input signal is attenuated from $Q_A$ (an intensity of the UHF signal measured just before the GIS section (M) for measuring the attenuation rate) to $Q_B$ (an intensity of the UHF signal passing through the GIS section (M) for measuring the attenuation rate).

5. The method according to claim 4, wherein, in the process (S300) of performing the location estimating algorithm, when the intensity of the signal measured by the sensor (A) is set to $Q_A$, when the intensity of the signal measured by the sensor (B) is set to $Q_B$, when a function in which the intensity of the signal that is gradually increased at the sensor (A) depending on a distance in a direction of the sensor (B) is expressed by $Q_A(x)$, and when a function in which the intensity of the signal that is gradually increased at the sensor (B) depending on a distance in a direction of the sensor (A) is expressed by $Q_B(x)$, a location of a partial discharge source is estimated to be a point at which $Q_A(x)$ and $Q_B(x)$ intersect each other.

6. The method according to claims 4 or 5, wherein, in the process (S400) of comparing the location coordinates of the tank at which the partial discharge occurs through the result of performing the algorithm with the coordinate system database of each tank of the GIS and determining the tank at which the partial discharge occurs, when n tanks are installed between the sensors (A and B), when length of the tanks are set to $l_1, l_2, \dots, l_n$, and when the attenuation rates previously measured and constructed into the database are set to $\alpha_1, \alpha_2, \dots, \alpha_n$, an attenuation phenomenon of each distance is represented in a linear form.

# FIG. 1

S100

S110 — CHECK LOCATION OF EACH TANK USING GIS DRAWING

S120 — CONSTRUCT RELATIVE COORDINATE DB OF EACH TANK

TANK COORDINATE DB

OCCURRENCE OF PARTIAL DISCHARGE (PD) IN GIS — S310

SELECT TWO SENSORS HAVING STRONGEST INTENSITY OF PD SIGNAL — S320 } S300

DETERMINE LOCATION COORDINATES OF TANK AT WHICH PD OCCURS — S330

S200

MEASURE PD ATTENUATION RATE OF EACH STRUCTURE OF GIS — S210

CONSTRUCT PD ATTENUATION RATE DB OF EACH STRUCTURE OF GIS

PD ATTENUATION RATE DB — S220

COMPARE LOCATION COORDINATES OF TANK AND ELECTROMAGNETIC WAVE ATTENUATION RATE DATABASE — S410

DETERMINE TANK AT WHICH PD OCCURS — S420 } S400

EP 2 574 941 A2

# FIG. 2

PD GENERATOR

INTERNALLY
MOUNTED
SENSOR

SECTION M

L

INTERNALLY
MOUNTED
SENSOR

EXTERNALLY
MOUNTED
SENSOR

$Q_A$

$Q_B$

EXTERNALLY
MOUNTED
SENSOR A

EXTERNALLY
MOUNTED
SENSOR B

PD
MEASUREMENT
EQUIPMENT

# FIG. 3

300

● DB:(ATTENUATION RATE,
COORDINATES)
● PD EVENT
GENERATION SENSOR
● SENSOR HAVING STRONGEST
SIGNAL INTENSITY OF PD
EVENT GENERATION SENSOR
AND NEIGHBORING SENSOR

PD LOCATION
ESTIMATING
ALGORITHM

● PD OCCURRENCE
LOCATION TANK

FIG. 4

ATTENUATION RATE : $\alpha_1$    ATTENUATION RATE : $\alpha_2$    ATTENUATION RATE : $\alpha_3$

DISTANCE : $l_1$    DISTANCE : $l_2$    DISTANCE : $l_3$

$l_1$    $l_1 + l_2$    $L = l_1 + l_2 + l_3$

Sensor A    Sensor B

EP 2 574 941 A2

# FIG. 5

ATTENUATION RATE : $\alpha_1$

DISTANCE : $l_1$

ATTENUATION RATE : $\alpha_2$

DISTANCE : $l_2$

ATTENUATION RATE : $\alpha_4$

DISTANCE : $l_4$

. . .

Sensor A

Sensor B

$l_1$    $l_1 + l_2$    $l_1 + l_2 + \cdots + l_{n-1}$    L $= l_1 + l_2 + \cdots + l_{n-1} + l_n$

EP 2 574 941 A2

FIG. 6

$Q_B + \alpha_1 l_1 + \alpha_2 l_2 + \alpha_3 l_3 + \alpha_4 l_4$

$Q_A + \alpha_1 l_1 + \alpha_2 l_2 + \alpha_3 l_3 + \alpha_4 l_4$

$Q_B + \alpha_4 l_4 + \alpha_3 l_3 + \alpha_2 l_2$

$Q_A + \alpha_1 l_1 + \alpha_2 l_2 + \alpha_3 l_3$

$Q_B + \alpha_4 l_4 + \alpha_3 l_3$

$Q_A + \alpha_1 l_1 + \alpha_2 l_2$

$Q_B + \alpha_4 l_4$

$Q_A + \alpha_1 l_1$

$Q_B$

$Q_A$

ATTENUATION RATE : $\alpha_1$

ATTENUATION RATE : $\alpha_2$

ATTENUATION RATE : $\alpha_3$

ATTENUATION RATE : $\alpha_4$

DISTANCE : $l_1$

DISTANCE : $l_2$

DISTANCE : $l_3$

DISTANCE : $l_4$